**Europäisches Patentamt**

**European Patent Office**

**Office européen des brevets**

(19)

(11) **EP 1 612 833 A1**

(12) **EUROPEAN PATENT APPLICATION**

(43) Date of publication:
04.01.2006 Bulletin 2006/01

(51) Int Cl.:
*H01J 37/302* (2006.01)

(21) Application number: 04103019.8

(22) Date of filing: 29.06.2004

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Leica Microsystems Lithography GmbH**
**07745 Jena (DE)**

(72) Inventors:
• **Hudek, Peter**
**07743, Jena (DE)**

• **Beyer, Dirk**
**99423, Weimar (DE)**
• **Melchior, Lemke**
**07751, Jena-Cospeda (DE)**

(74) Representative: **Reichert, Werner Franz**
**Leica Microsystems AG,**
**Corporate Patents + Trademarks Department,**
**Ernst-Leitz-Strasse 17-37**
**35578 Wetzlar (DE)**

(54) **Method for reducing the fogging effect**

(57) Method for reducing the fogging effect in an electron beam lithography system wherein the exposure is controlled in order to obtain resulting pattern after processing which are conform to design data. A model for the fogging effect is fitted by individually changing at least the basic input parameters of the Gaussian function $G_{fog}$. The proximity effect is considered as well and an optimised set of parameters is obtained in order to gain a control function for the proximity effect. The pattern writing with an e-beam lithographic system is controlled by the combined proximity effect control function and the fogging effect control function.

Fig. 1

EP 1 612 833 A1

**Description**

The invention refers to process for controlling the proximity effect correction in an electron beam lithography system. The process is suitable for precise numerical determination of the proximity parameters of the Point Spread Function (PSF) for optimised controlling the proximity correction in the high-resolution electron beam lithography (EBL).

The proximity effect parameters are specific numerical inputs to control an arbitrary Proximity-Effect correction software. This satisfies high Critical Dimension control "CD-control" requirements (depending on actual International Technology Roadmap for Semiconductors ITRS from International SEMATECH) as well as to compensate pattern bias in the Mask and/or Direct-Write working with Gaussian and/or Shaped beam in connection with the subsequent technology steps (development, etching, etc.).

Many methods have been proposed for the determination of the proximity parameters reflecting various effectiveness. In addition to the proximity effect a fogging effect occurs simultaneously in a electron beam lithographic system. There are several publications, which deal with the proximity effect correction.

The article "Optimum PEC Conditions Under Resist Heating Effect Reduction for 90nm Node Mask Writing"; disclosed in Proc. SPIE, Vol. 4889, Part Two, pp 792-799 (paper No. 86), show the problem of 50kV e-beam writing causing critical dimension (CD) change, resist heating and proximity effect. This experimental method is used for determination of the proximity input-parameters in the mask making process using large area matrices of proximity-corrected test patterns written under various conditions with discrete step-by-step individually changed proximity parameters. The optimal parameter set is then determined from direct measurements on these test patterns where the pattern deformation effects are minimal. The experiment and also the pattern evaluation is highly time consuming. Because of the large number of possible combinations of the input parameters, the method is limited to only 2 Gaussian approximation of the resulting PSF. This method is massively used in the mask production.

The article in Microelectronic Engineering 5 (1986) 141-159; North Holland with the title "Determination of the Proximity Parameters in Electron Beam Lithography Using Doughnut-Structures". The test structures, used to determine the parameters for a correction function, are doughnuts. This method offers a straightforward technique for determining the proximity parameters from an array of exposed donuts by means of optical microscopy. This method is not sensitive enough to achieve CD control with a e-beam and not suitable for high-resolution patterning EBL methods.

In the article "Point Exposure Distribution Measurements for Proximity Correction Electron Beam Lithography on a sub-100 nm Scale"; in J. Vac. Sci. Technol. B 5(1), Jan/Feb 1987 a single point/pixel is exposed in a wide range of doses and the diameters of the patterns measured and the results directly approximated by Gaussian functions. The method is applicable for special high-contrast resist only (i.e. insensitive to changes in development rate effects), needs high-resolution measurement technique (SEM) and also additional processes ("lift-off" or deposition coatings of patterns). This method may not be applicable to the commercially used Chemically Amplified Resists (CAR). With the point exposure method using extremely high doses, acid diffusion effect may outweigh the true nature of the proximity effect [Z. Cui, Ph.D. Prewett, "Proximity Correction of Chemically Amplified Resists for Electron Beam Lithography", Microelectronic Engineering 41/42 (1998) 183-186].

The article "Determination of Proximity Effect Parameters in Electron-Beam Lithography" in J. Appl. Phys. 68 (12), 15. December 1990, discloses a empirical method for determining the proximity parameters in electron-beam lithography from rectangular array of mesh patterns from which, after the processing proximity parameters should be retrieved by means of light-optical inspection. A test pattern to be measured is used to determine the proximity effect. This method is not suitable for the contemporary conventional high-resolution production e-beam lithography systems.

In some publications the fogging effect is considered as well. The article "Fogging Effect Consideration in Mask Process at 50 KeV E-Beam Systems" shows a suggestion to reduce the fogging effect in high voltage electron e-beam systems. The fogging effect influences

The article in Microelectronic Engineering 5 (1986) 141-159; North Holland with the title "Determination of the Proximity Parameters in Electron Beam Lithography Using Doughnut-Structures".

The article "Determination of Proximity Effect Parameters in Electron-Beam Lithography" in J. Appl. Phys. 68 (12), 15. December 1990, discloses a.

It is the object of the present invention to create a method which allows a reliable correction of the illumination parameters of a e-beam lithographic system by considering the influence of the fogging effect.

The above object is achieved by a method as claimed in claim 1

It is advantageous if the method comprising the steps of:

• exposing test patterns;

• measuring the geometry of the resulting test structures within the test pattern and thereby obtaining a set of measurement data showing the influence of the fogging effect on the dimensions as required by the design data;

- determining a numerical range of basic input parameters for a Gaussian function $G_{fog}$ , describing the fogging effect, from the set of measurement data;

- fitting a model for the fogging effect by individually changing at least the basic input parameters of the Gaussian function $G_{fog}$, by considering a proximity effect, to measurement data set and thereby obtaining an optimised set of parameters,

- applying the correction function to an exposure control of the electron beam lithography system during the exposure of a pattern according to the design data.

Additionally, it is useful to apply the determined proximity parameter set to a calculation and comparison of the results with the measured data set with nominal doses exposed isolated clear and opaque lines, "ON THE TARGET". Another possibility is to apply the fitted proximity parameter set to a calculation and a comparison of the results with the measured data set from other arbitrary pattern, which is a pyramid like pattern and comparing the results with the measured data set from measurements in representative points on the test patterns. A further possibility is to apply the fitted proximity parameter set to a calculation and a comparison of the results with the measured data set from other arbitrary pattern, which is a plurality of lines in Duty-Ratio and comparing the results with the measured data set from measurements in representative points on the test patterns.

The method is based on the analysis of the pattern geometry variation as a direct process response (electron energy, resist material, substrate material, pre- and post-exposure processes, pattern transfer, etc.) to non-interacting and/or interacting non-corrected patterns in the EBL. The measured pattern-variation behaviour is reconstructed using a back-simulation by inserting the specified proximity parameters into the model. From the model calculated data represent the lateral contour localizations of the simulated pattern at the same points where they were measured on the real pattern. A comparison of measured data with the calculated results at the same points on a representative test pattern (single clear/opaque lines, pyramid like patterns, array of lines in duty-ratio, etc.) visualise the quality of the determined proximity parameter set.

In the case, that the requested requirement, - that the correction algorithms are working under the same model conception as used in the model - is fulfilled, the method all at once also predicts the possible pattern uniformity deviations (pattern conformity) and the resolution limits after using the actually determined proximity parameter set in the proximity correction.

The present invention has the advantage that uses a model-based analyses and interpretations of native geometrical distortions of exposed non-corrected representative patterns (analysing the direct process response as a typical pattern-geometry variation) which are measured in specified points (using commercial measuring tools, e.g. CD-SEM) and the data are recorded for the subsequent processing. A successive "back-simulation" procedure is used for the best possible reconstruction of these effects. "Back-Simulation" means a computational method how to find the optimum numerical input parameter set for the best approximation of the measured geometry variation of a concrete pattern detail in dependence on pre- and post exposure condition and/or proximity (pattern-size and neighbourhood) effects (= pattern and process reconstruction). Once such a pattern detail can be the dimensional variation of a pattern in a specified point as a function of the exposure intensity (e.g. in the simplest case line width and/or contact dimensional variation vs. exposure dose in both tonalities). Another variable can be for example the location of a neighbourhood pattern (e.g. line width measurements vs. gap width variation of large pads - pyramid-like patterns, and/or lines in gratings - lines in duty-ratio). In consequence, after inserting the obtained parameters into the model, the appropriate simulations should show the same tendency of pattern geometry variations dependency as obtained from measurements. Accordingly, if the correction algorithms are working under the same model conception as used in the model, it results in a good recovery of the parasitic distortion effects using these input parameter sets in the proximity correction.

Measurements and simulations can be performed down to the smallest resolvable pattern dimension, which allows also a precise determination of parameters describing the so known "short-range" effects arising from the forward scattering of electrons, secondary electron distribution, beam blur, resist effects (development, acid diffusion, quenching) and pattern transfer (microloading). Consequently, the proximity corrector with working with this parameter set will be able to work correctly also in the deep sub-100nm lithography node.

Experimental measurements on a couple of exposed patterns (described in Appendix "Test patterns") are the precondition to provide all necessary numerical inserts into the PROX-In (PROX-In is a user-friendly Windows™ based software tool serving as a help for lithographers to determine the proximity effect parameters) active-free edit dialog boxes and to create simple ASCII-files containing the measured data. Subsequently these data serve as the basis for the selected particular built-in algorithms required for the proximity parameter determination in this program. To maximally avoid pattern degradations/distortions with submicron features it is unavoidable to apply a correction method for handling this effect. Existing techniques rely on: a) shot-by-shot modulation of the exposure dose, b) a modification of the pattern geometry, or c) combining of both methods mentioned before.

The main advantages of this process is, that it does not employ large matrices of exposed proximity-corrected patterns with various input parameters. The parameters will be here determined from measurements on non-corrected simple test patterns. The amount of data and/or parameters to be analysed are reduced enormously. The advantage of the present invention is as follows. The present invention uses only a small amount of a relatively simple set of test patterns exposed. The substrate (5-inch and larger) area covered by the test pattern which is limited to under 1%. Furthermore the test patterns are exposed without any proximity correction. Additionally there is the possibility to vary the global pattern loading by help of substrate "dummy" exposures of additional assistant patterns around the test patterns. This allows to determine the changes of pattern load depending on bias in the development and/or etching process. There is the additional possibility to directly observe the tendency of pattern degradation by individual varying the value of one of the input parameters. Then there is an interactive fine-tuning of the input parameters to achieve the best possible CD-requirements (CD-Linearity). The use of two or more Gaussian input parameter sets (Gaussian functions) with a direct check possibility, where and why the additional Gaussian functions with the various parameters are needed, enable the to achievement of better results. The back-simulation and reconstruction of specific pattern details for arbitrary proximity parameter sets allows a prediction of possible changes in the CD for the given parameter set for various geometry combinations of patterns.

A computer program "PROX-In" was developed and realized for optimisation and testing purposes of the method described in this application under real conditions in the production.

The "long range" fogging effect is considered as well. With the combination of the proximity correction control function and the fogging correction control function with the e-beam lithographic system, the dimensional errors are reduced to less than 10nm for the 100nm device generation.

The nature and mode of operation of the present invention will now be more fully described in the following detailed description of the invention taken with the accompanying drawing figures, in which:

Fig. 1 is a block diagram of an e-beam lithographic system;

Fig. 2a is an example for a pattern written with a Gaussian beam;

Fig. 2b is the shape of the cross section of the Gaussian beam, which has a constant diameter;

Fig. 3a is an example for a pattern written with a shaped beam;

Fig. 3b is the shape of the cross section of the shaped beam, wherein the shape can be adjusted according to the pattern which needs to be written;

Fig. 4a shows simulated trajectories for 100 electrons scattered in a Poly-(Methyl-MethAcrylate) (PMMA) coated on a GaAs substrate;

Fig. 4b shows simulated trajectories for 100 electrons scattered in a Poly-(Methyl-MethAcrylate) (PMMA) coated on a GaAs substrate, wherein the primary energy of the electrons is higher as in the calculation shown in Fig. 4a;

Fig. 5 is a diagram showing the fogging effect as a function of the energy of the primary energy of the e-beam;

Fig. 6 is a schematic view of the form of a first test pattern used to determine the fogging effect on the dimension of specific structures;

Fig. 7 is a schematic view of the form of a second test pattern used to determine the fogging effect on the dimension of specific structures;

Fig. 8 is a diagram showing the measured dose in arbitrary units along a line which is perpendicular to the exposed line and extends to one edge of the exposed large area of the second test pattern;

Fig. 9 is a diagram showing the measured dose in arbitrary units (relative intensity) along a line which is perpendicular to the exposed line and extends 200nm to the left and to the right of the exposed line;

Fig. 10 shows a first test pattern which is written into the resist;

Fig. 11 shows a second test pattern which is written into the resist;

Fig. 12 shows an input window for the user to initiate the exposure of the first test pattern as shown in Fig. 10;

Fig. 13 shows a table of measurement result gained from the exposed first test pattern;

Fig. 13a shows the result gained from the exposed first test pattern;

Fig. 14 shows an PROX-In input window for the user to initiate the procedure of the second "DRT" test pattern;

Fig. 15 shows a table of measurement result gained from the exposed second test pattern;

Fig. 15a shows the result in a graph form from PROX-In;

Fig 16 shows the main window of the program PROX-In provided on the display associated with the computer;

Fig. 17a shows a table of a exposed line width as a function of the applied dose;

Fig. 17b shows a change in line width as a function of the dose exposed;

Fig. 18 shows the parameter-determination fitting process using the Back-Simulation method and a "2G" approximation;

Fig. 19 shows the parameter-determination fitting process using the Back-Simulation method and a "3G" approximation;

Fig. 20 shows the comparison of the optimal doses for a measured line width of a single clear line and the simulated one; using "2G" approximations;

Fig. 21 shows the comparison of the optimal doses for a measured line width of a single clear line and the simulated one, using "3G" approximations;

Fig. 22 shows a graph representation of the resulting control function;

Fig. 23 shows a schematic representation of a pattern written with and without the applied control function; and

Fig. 24 shows a combined control function.

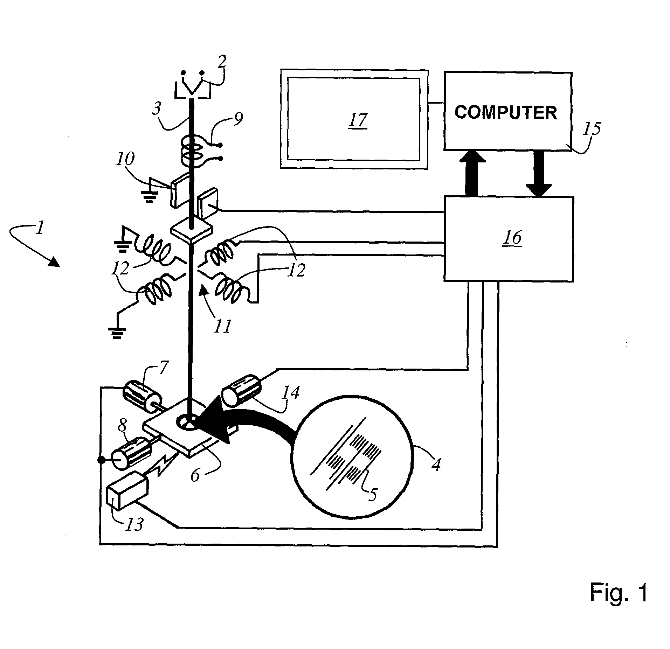

Fig. 1 shows a block diagram of an e-beam lithographic system 1. The e-beam lithographic system 1 has an e-beam source 2 which emits an e-beam 3. The specification mentions the use of an e-beam 3 only. Nevertheless, it has to be understood that the invention is not limited to e-beams only. The invention can be used with particle beams in general, which are applicable to write a pattern 5 on substrate 4. The substrate 4 itself is placed in stage 6 which can be moved by electric motors 7 and 8 in a plane which is spanned by the X-coordinate X and the Y-coordinate Y. The e-beam 3 passes beam alignment coil 9 after the emerge from the e-beam source 2. After the beam alignment coil 9, in the direction of e-beam 3 propagation, a beam blanking unit 10 is provided. After that the e-beam 3 reaches a magnetic deflection unit 11, which comprises in general four magnetic coils 12. After that the e-beam 3 is directed to the substrate 4. As already mentioned the substrate 4 is positioned on the stage 6. The actual position of the stage is controlled by a position feedback device 13. Additionally, an electron detector 14 is positioned in close proximity of the stage 6. A computer 15 is provided for controlling the whole e-beam lithographic system 1. Especially, to control, measure and adjust the beam parameters in order to produce pattern with a constant dimension. The computer 15 is linked to the e-beam lithographic system 1 by an interface 16, which carries out the analog to digital and/or the digital to analog conversion. The interface 16 is connected to the beam blanking unit 10, the magnetic deflection unit 11, position feedback device 13, the electron detector 14 and the electric motors 7 and 8 for moving the stage 6. The user is informed via a display 17 about the settings and/or the adjustment parameters of the e-beam lithographic system 1.

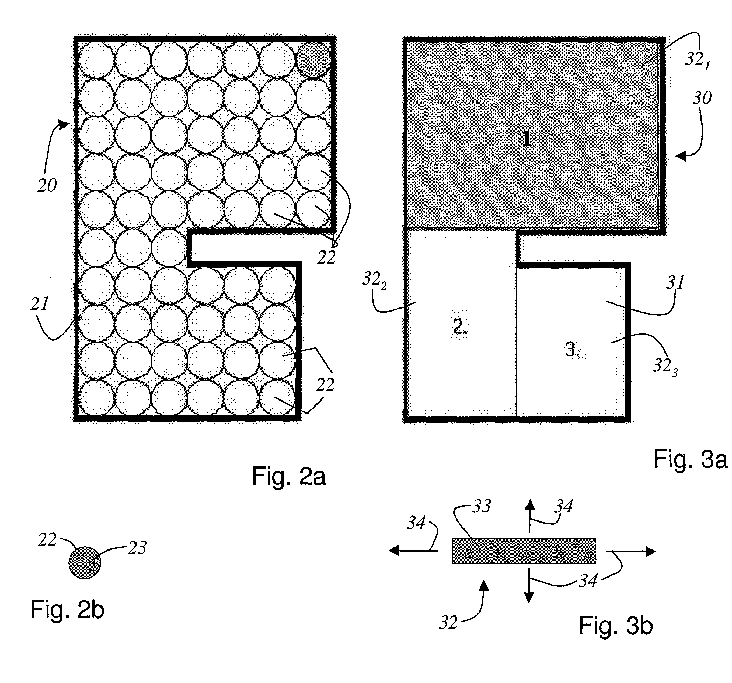

Fig. 2a is an example for a pattern 20 which covers a certain area 21 and the area 21 is filled with a plurality of Gaussian beams 22. Each of the Gaussian beams 22 has the same diameter. In Fig. 2b the shape of the cross section 23 of the Gaussian beam 22 is shown. The plurality of beams cover the area 21, which the pattern 20 requires.

Fig. 3a shows an example for a pattern 30 which is written with a shaped beam 32. The total area 31 of the pattern 30 is cover by a plurality of variable shaped figures. The variable shaped figures fill the area of the pattern 31 to be written. In the present case the area 31 is covered by three different shapes $32_1$, $32_2$ and $32_3$ of the electron beam. Fig. 3b shows the shape of the cross section 33 of the shaped beam 32, wherein the shape of the individual beams can be adjusted according to the pattern which needs to be written. As shown in Fig. 3b, the shape of the beam can be changed. This is indicated by the arrows 34.

In both cases (Gaussian beam or Shaped beam) the submicron features or pattern became the crucial factor for mask writing. With this pattern size, e-beam lithographic systems are confronted with common parasite electron scattering effects, which cause unwanted exposure depositions in the area surrounding the pattern to be written. This parasite electron scattering effects are known as proximity effects (see for example: T. H. P.Chang, "Proximity effect in electron beam lithography," J. Vac. Sci. Technol. 12 (1975) p.1271). In case the minimum feature size becomes less than the backscattered range of electrons, pattern coverage affects the dimensional control of the pattern to be written. On the other hand, forward scattering limits the maximum resolution. The difference between back-ward and forward scattering increases as the energy of the electrons increases. Any pattern detail, which falls within a specific area, suffers significant distortions from his originally designed size and shape in the realized resulting lithographic pattern image. To maximally avoid pattern degradations/distortions with submicron features it is unavoidable to apply a correction method for handling this effect.

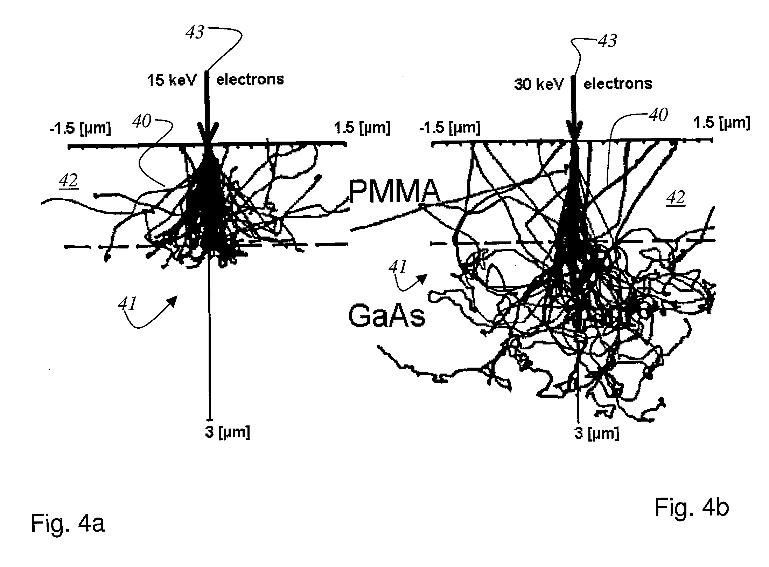

Fig. 4a shows simulated trajectories 42 for one hundred electrons scattered in a Poly-(Methyl-MethAcrylate) layer 40 (PMMA), which defines a resist, coated on a GaAs substrate 41. The primary energy of the electrons is set to 15 keV. As the e-beam 43 impinges on the PMMA-layer the electrons are scattered and move according to the calculated trajectories. Fig. 4b shows simulated trajectories for 100 electrons scattered in the PMMA-layer 40 coated on a GaAs substrate 41, wherein the primary energy of the electrons is higher as in the calculation shown in Fig. 4a. In electron beam lithography the dominant distortion originates from the interaction of electrons with the resist/substrate system convoluted with additional effects, which are not exactly detachable and separately treatable. Here the major role plays the absorbed energy density distribution (AEDD) spread in the resist with the corresponding radiation-chemical event distribution in the resist volume creating the latent image (resist differentiation) in the resist. A modeling of the AEDD in the resist layer is possible by using statistical (Monte Carlo) or analytical (Transport Equation) calculations of electron-scattering processes. The real latent image is then created by local chemical modifications of the irradiated resist volume after absorbing a necessary radiation quantum from the exposure.

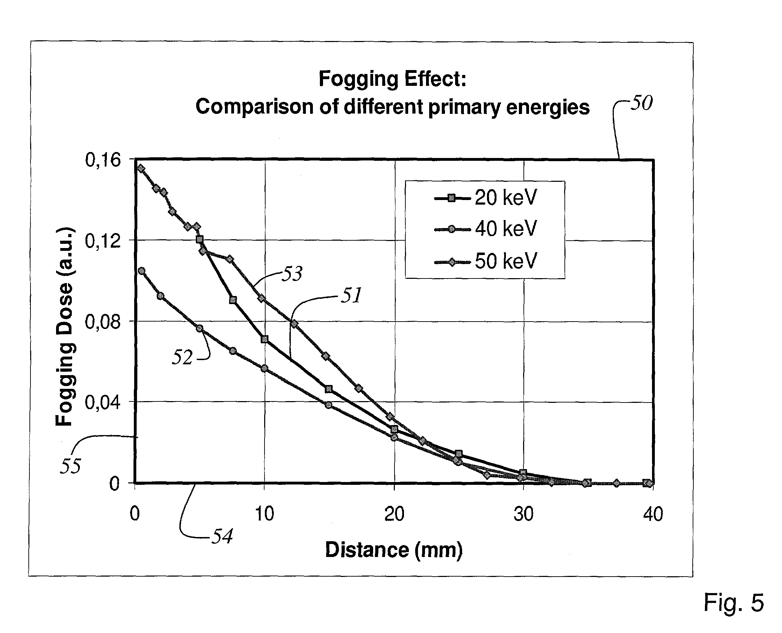

Fig. 5 shows a diagram 50 displaying the fogging effect as a function of the energy of the primary energy of the e-beam. The fogging effect is a multiple scattered background exposure, which is generated by the long range effect of the background exposure. The fogging dose for three different electron beam energies 51, 52 and 53 is determined. The first electron beam energy 51 is 20keV. The second electron beam energy 52 is 40keV. The third electron beam energy 53 is 50keV. The diagram 50 shows clearly that for all the electron energies a dose impact is recognizable at least 35 mm away from the impact point of the electron beam. On the abscissa 54 the distance from the location is shown in mm, where the electron beam hits the target. The ordinate 55 displays the fogging dose in arbitrary units.

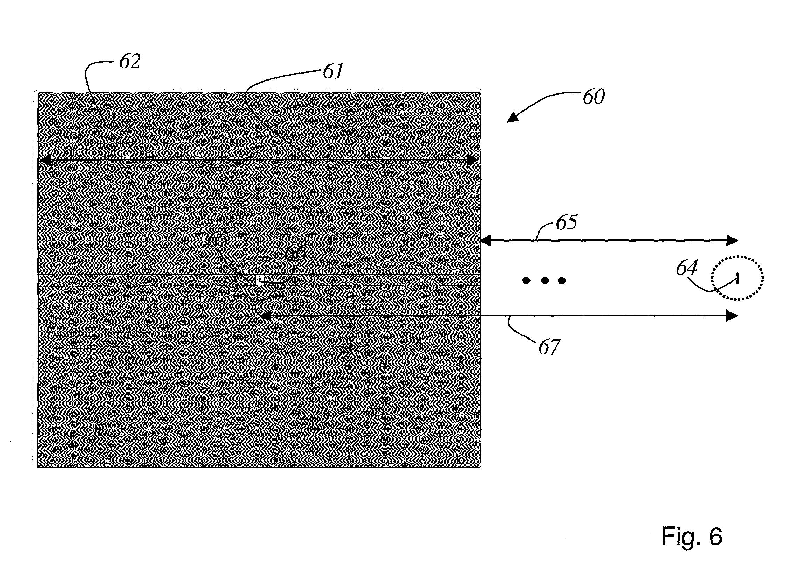

Fig. 6 is a schematic view of the form of a first test pattern 60 used to determine the fogging effect on the dimension of specific structures. The test pattern comprises an exposed area 62 with a width 61 of approximately 10000 $\mu$m. Within the exposed area an island 63 is not exposed except an exposed line 66 in the middle of the island 63. A clear line 64, of a width of 200nm, is exposed at a distance 65 of 45.000 $\mu$m from the exposed area 62. The clear line 64 is parallel to the exposed line 66 in the middle of the island 63. The clear line 64 and the exposed line 66 in the middle of the island 63 are separated by a distance 67 of 50.000 $\mu$m. Measurements show that the width of the clear line 64 separated by 45.000 $\mu$m from the exposed area 62 is not affected by any fogging effect.

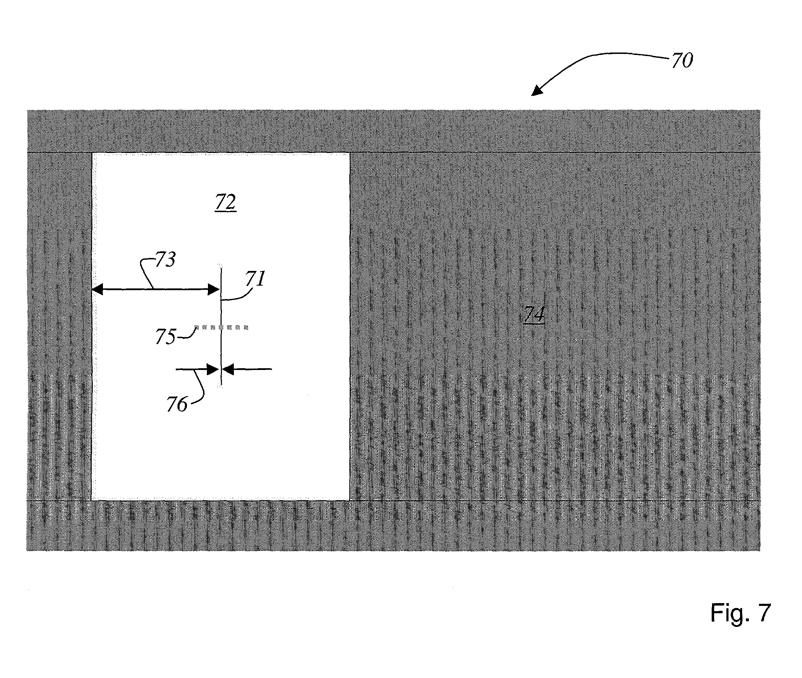

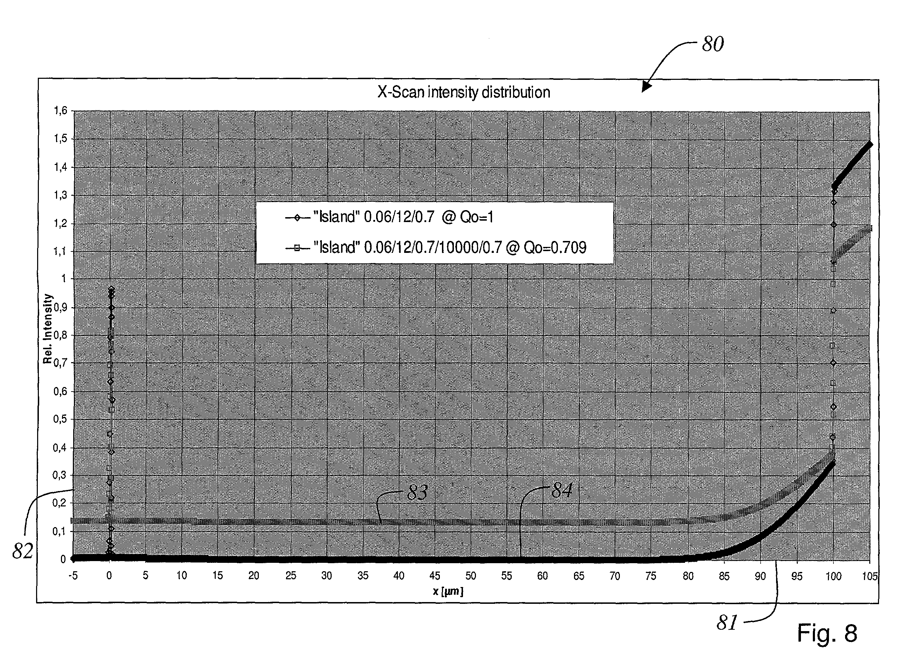

Fig. 7 is a schematic view of the form of a second test pattern 70 used to determine the fogging effect on the dimension of specific structures. A single line 71 is exposed within an unexposed area 72. The distance 73 of the single line 71 from the edges of the unexposed area 72 is 100 $\mu$m. The width 76 of the line 71 is 200 nm. The of the unexposed area 72 is surrounded by a large exposed area 74. A measurement scan 75 of the dose is carried out perpendicular to the exposed single line 71. Fig. 8 is a diagram 80 showing the measured dose in arbitrary units along a line which is perpendicular to the exposed single line 71 and extends to one edge of the exposed area 74 of the second test pattern 70. The abscissa 81 of the diagram 80 represents the position along the line which is in direction of the X-coordinate. The ordinate 82 shows the measured dose at the respective position in arbitrary units. The a first curve 83 of the diagram 80 shows the measured dose with fogging effect and a second curve 84 shows the measured dose without the fogging effect. The fogging effect causes the first curve 83 to have a higher dose level than the second curve.

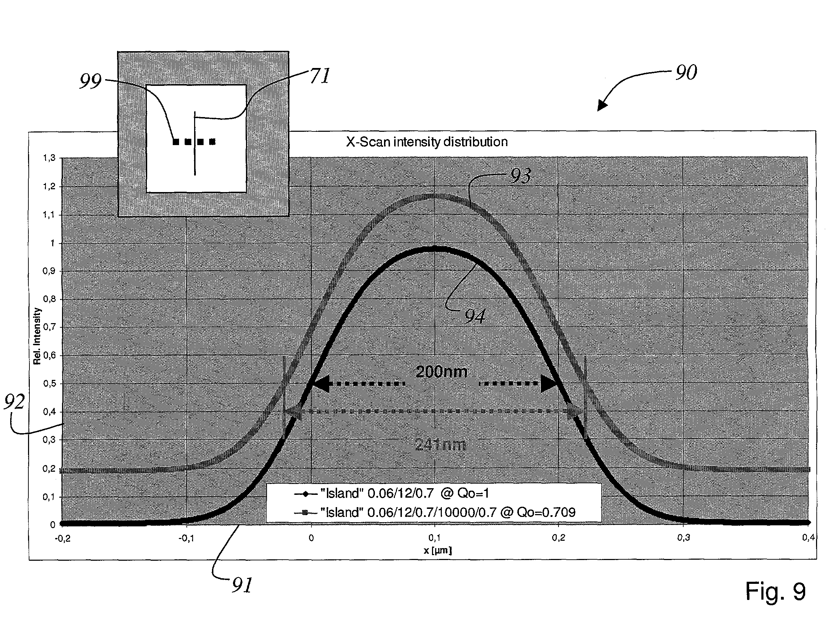

Fig. 9 is a diagram 90 showing the measured dose in arbitrary units (relative intensity) along a line 99 which is perpendicular to the exposed single line 71 and extends 200nm to the left and to the right of the exposed single line 71. The abscissa 91 of the diagram 90 represents the position along the line 99 which is in direction of the X-coordinate. The ordinate 92 shows the measured dose at the respective position in arbitrary units. The a first curve 93 of the diagram 90 shows the measured dose with fogging effect and a second curve 94 shows the measured dose without the fogging effect. As already stated in Fig. 8, the fogging effect causes the first curve 93 to have a higher dose level than the second curve 94. With the second test pattern 70 it is the intention to expose a line and obtain a resulting width 96 of 200 nm. Without the fogging effect this goal is achieved. Taking the fogging effect into account the resulting width of the line would be 241 nm. The increased width 95 is caused by the additional dose contributed to the exposure by the fogging effect.

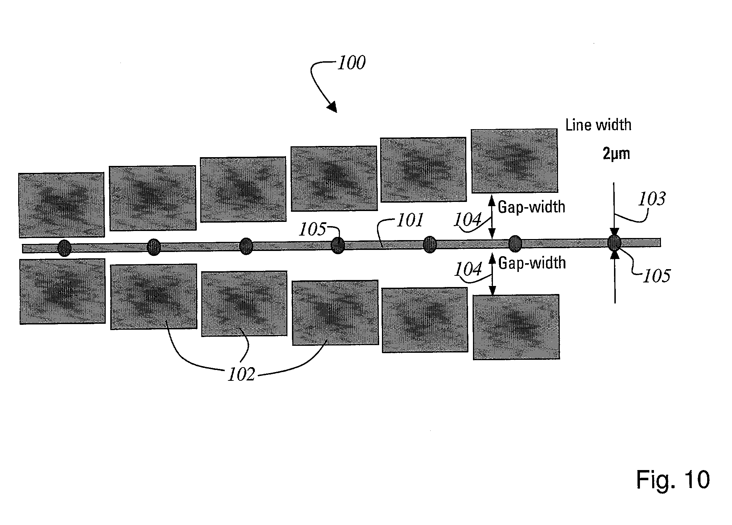

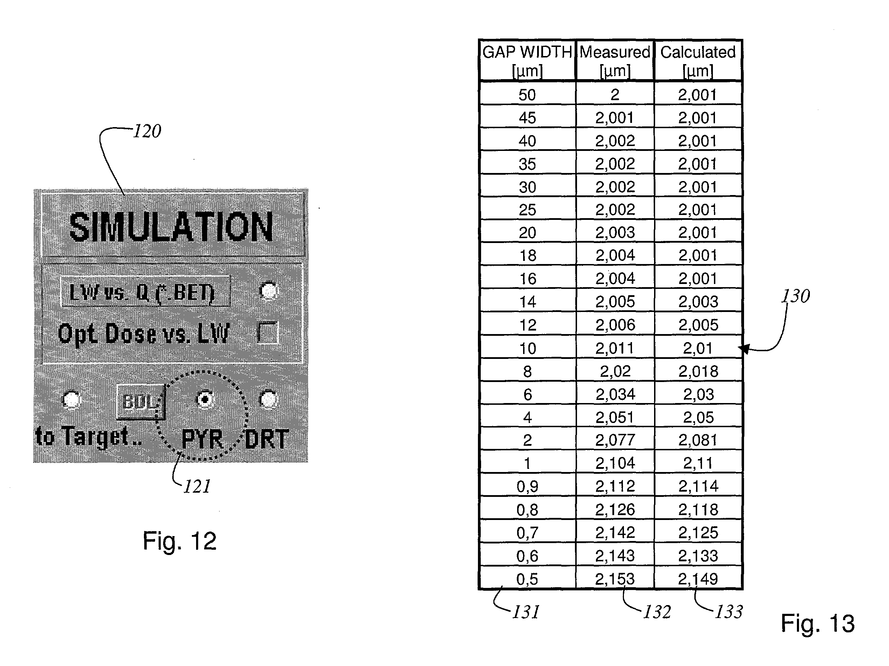

Besides the fogging effect, which is a long range effect, the proximity effect, which is a short range effect, needs to be considered as well. One option to consider the proximity effect is described below. Fig. 10 shows a first possible (already implemented in PROX-In) test pattern 100 which is written into the resist. The procedure to back-simulate this first test pattern 100 is named pyramid "PYR" (uses a pyramid-like test pattern 100). This special process can be initiated by the user via the PROX-In user interface (see Fig. 12). The procedure allows to determine the input parameters after analyzing the experimentally measured data from line width variation of the exposed symmetrical pyramid test pattern 100. The first test pattern 100 contains one line 101, which has a predefined line width 103. On both sides of the predefined line 101 large pads 102 are exposed with a varying gap width 104 along the measured line 101. In the non-corrected case the predefined single clear line width 103 increases with decreasing gap width 104 between measured line 101 and large pads 102. The measurement is taken at locations which are marked with points 105 in Fig. 10.

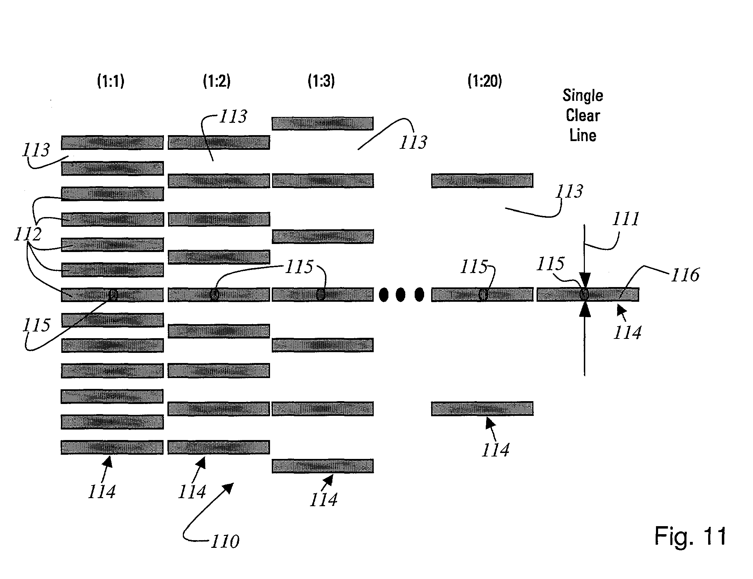

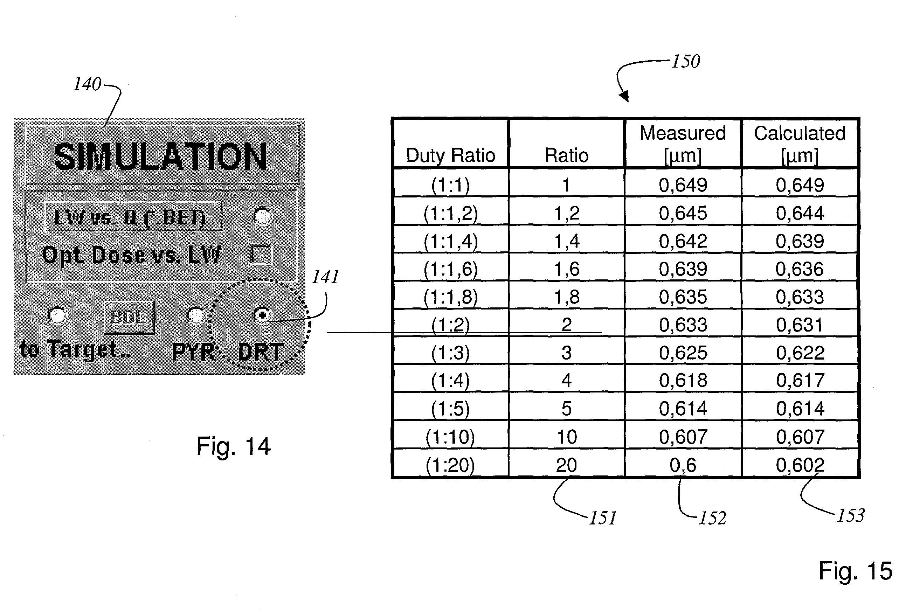

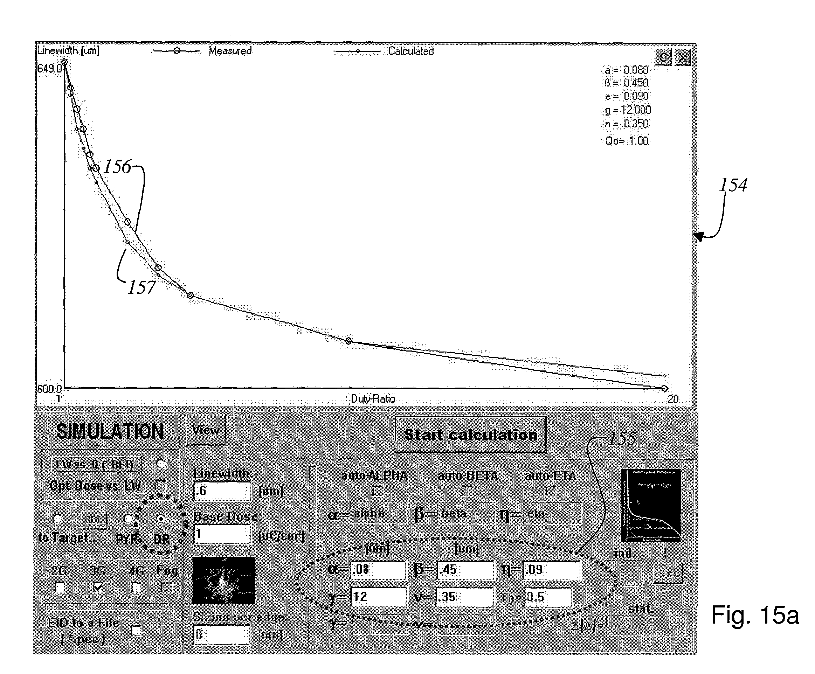

Fig. 11 shows a second possible test pattern 110 also already implemented in PROX-In which can be used for the direct proximity parameter determination. Similar to the other previously described method, this procedure is based on line width 111 measurements of exposed non corrected Duty-Ratio-Test patterns "DRT". A plurality of lines 112 are exposed in the resist and/or further processed. The lines 112 are created in arrays 114 of various pitches 113 between the lines. This special process can be initiated by the user via a special PROX-In user interface (see Fig. 14). The procedure allows to determine the proximity input parameters after analyzing the experimentally measured data from representative line 115 width variation of the exposed symmetrical second test pattern 110. To receive the acquired file (see Fig. 15), data in two columns in the form are provided. The first column 151 is the Duty-Ratio parameter as a number 1, 2, 3, ..., 20 of the ratio (1:1, 1:2, 1:3, ..., 1:20). The second column 152 is the measured line width to the appropriate ratio in $\mu$m. The third column 153 is the calculated line width. It is necessary to measure the variation of the line width somewhere from the middle of each array 114 for various Line/Space rates. Bullet points 115 in Fig. 11 indicate the locations where the measurements are taken. It is important that before starting the "DRT" measurement procedure it is necessary to determine the optimum exposure dose for the single-clear-line 116 on the right side of the second test pattern 110. In other word the measured single clear line has the line width as required by the CAD-data and the patterned line meets the target as good as possible.

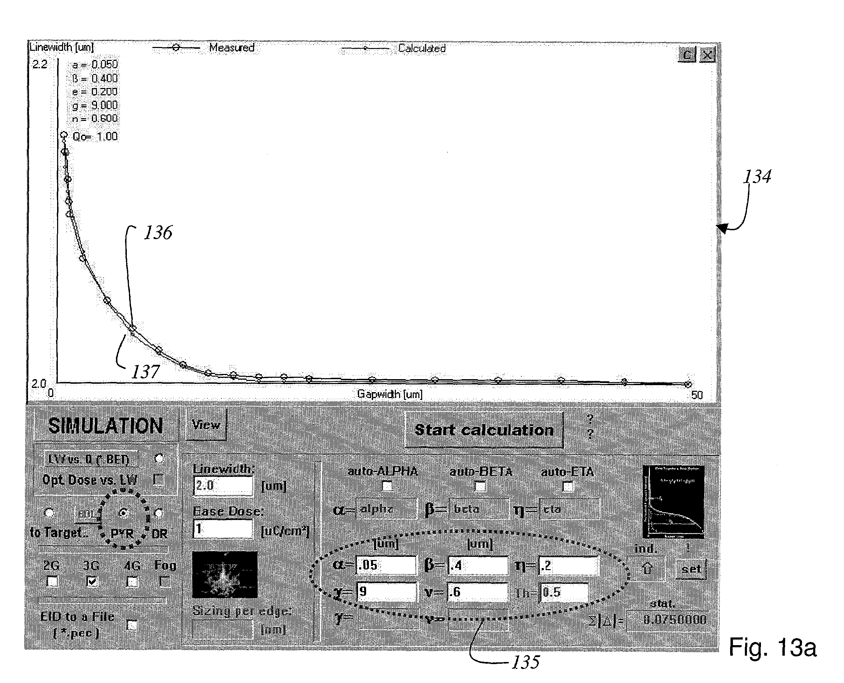

Fig. 12 shows an input window 120 for the user to initiate the exposure of the first test pattern 100 as shown in Fig. 10. The user selects the pyramid procedure by setting a mark (check the "PYR" button) 121 above the indicated "PYR" name and the back-simulation procedure starts. The result is shown in a table 130 (see Fig. 13). The measurement result, gained from the exposed first pyramid test pattern 100 is disposed in the second (middle) column 132. The first column 131 shows the gap width and the third column 133 shows the from simulation back-simulated / reconstructed / calculated line width 133 for the given determined input parameter set. Fig. 13a shows the result in a graph form 134 from PROX-In, where the goal is to find such a parameter set 135, which provides the best coincidence of measured data 136 with calculated ones 137.

Fig. 14 shows an PROX-In input window 140 for the user to initiate the procedure of the second "DRT" test pattern 110 as shown in Fig. 11. The user selects the Duty-Ratio-Test procedure by setting a mark 141 above the indicated "DRT" name (check the "DRT" button) and the calculation process starts. The result is shown in a table 150 (see Fig. 15). The measurement result, gained from the exposed second test pattern 110 is disposed in three columns. The first column 151 contains data with the Duty-Ratio, the second column 152 contains data with the measured line widths and the third column 153 contains the calculated line widths from the back simulation.

Fig. 15a shows the result in a graph form 154 from PROX-In, where the goal is (also the same as in the previous case with the pyramid-pattern) to find such a parameter set 155, which provides the best coincidence of measured data 156 with calculated ones 157.

It is obvious that other test patterns may be designed and used in order to gain additional experimental and simulated data to which the determined proximity parameters has to be cross checked and fitted. The fit provides a parameter set which allows exposure of couple of micro-patterns and the result gained is highly conform with the provided design data for the required pattern. In other words: any pattern exposed with the process according to the present invention result in patterns which have a dimension as required according to the design data. In addition to the proximity effect correction the correction with regard to the fogging effect has to be provided.

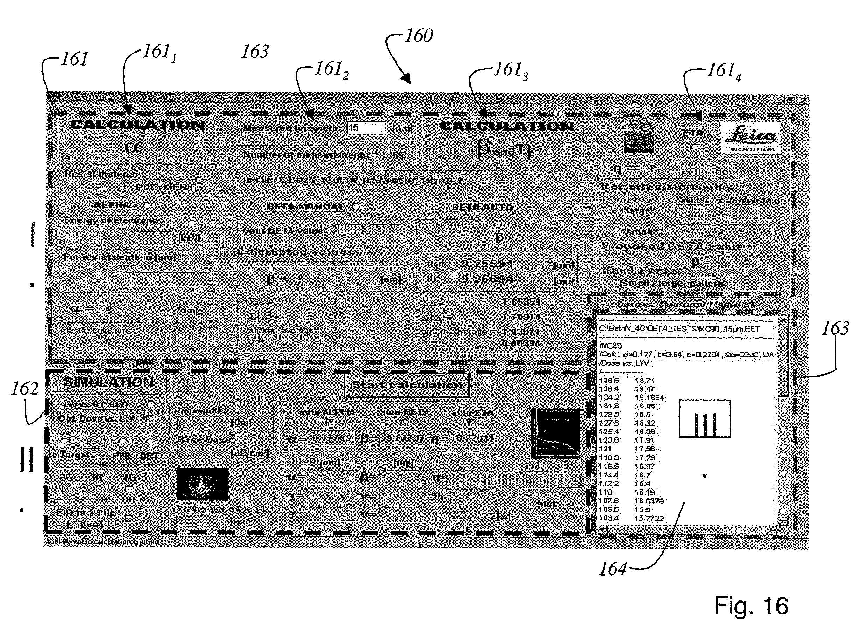

The PROX-In and the correction with respect to the fogging effect runs on a standard computer 15 (see Fig. 1). The computer 15 runs under Windows and does not need any specific hardware/software features. The general structure of PROX-In plus the fogging correction is clear from the main window 160 shown on a display 17 associated with the computer 15. The main window appears immediately after starting the program PROX-In (see Fig. 16). The main window 160 is divided into three main parts. A first part 161 is in the whole upper half of the main window 160. The first part is headed as "CALCULATION $\alpha$" and "CALCULATION and ". The first part 161 consists of a first, second third and fourth separate sub-box $161_1$, $161_2$, $161_3$ and $161_4$. The first sub-box $161_1$ is captioned as "ALPHA". The second sub-box $161_2$ is captioned as "BETA-MANUAL". The third sub-box $161_3$ is captioned as "BETA-AUTO". The fourth sub-box $161_4$ is captioned as "ETA". The sub-boxes serve for the quick and very first evaluation of the lithographic process response from measurements of relatively large patterns/wide lines and delivers the first (rough) numerical approach for the proximity parameters.

A second part 162 is poisoned at the bottom of the main window 160. The second part 162 is headed as "SIMULATION" and serves for the final "fine-tuning" of the parameters based on the best pattern reconstruction using back-simulation.

A third part 163 is located in the right-bottom side of the main window 160. The third part 163 is a scrolled "Input/Output" MEMO-box with a text window 164, where some necessary information appear that result from the selected operations/calculations.

New e-beam lithographic systems are designed to satisfy the CD-requirements at 100nm device generation level and below. To meet these specifications it is necessary to have an adequate knowledge base covering all pattern-degradation/distortion effects through the whole process and also the consecutive application of the accurate correction methods.

The proximity correction control function $f(r)$ is usually described as a sum of two or more Gaussian functions (see Equation. 1). In the case of a normalized 2G-function it reads as follows:

$$f(p) = \frac{1}{\pi(1+\eta)} \left\{ \frac{1}{\alpha^2} \exp(-\frac{r^2}{\alpha^2}) + \frac{\eta}{\beta^2} \exp(-\frac{r^2}{\beta^2}) \right\} \qquad \text{Equation 1}$$

where the first term $\alpha$ - characterizes the short-range of forward scattering, the second term $\beta$ - the backscattering , the parameter $\eta$ - is the deposited energy ratio of the back-scattering component to the forward scattering component, and r- is the distance from the point of electron incidence (see Fig. 4a).

The correction of the fogging effect (long range) is carried out with at least one Gaussian function $G_{fog}$, which describes the fogging correction control function:

$$f(f) = G_{fog} \qquad \text{Equation 2}$$

Additionally, the correction of the proximity effect (short range) and the fogging effect (long range) is achieved by applying proximity correction control function $f(r)$ and the fogging correction control function $f(rf)$ simultaneously. It should be noted once again that application of the above described proximity correction control function is only one possibility.

According to the present embodiment the overall control function is:

$$f(r) = f(p) + f(f)$$

which reads

$$f(r) = \frac{1}{\pi(1+\eta)} \left\{ \frac{1}{\alpha^2} \exp(-\frac{r^2}{\alpha^2}) + \frac{\eta}{\beta^2} \exp(-\frac{r^2}{\beta^2}) \right\} + G_{fog} \quad \text{Equation 3}$$

The final resist-relief mask will be obtained after the application of a post-exposure process (mostly a wet process) in a suitable developer. For the modeling and prediction of the real resist pattern geometry, the dissolution behavior of the polymer modified by radiation needs be exactly known. The development process brings into the whole simulation of a large amount of uncertainties, because of the highly non-linear behavior of this complicated thermo-hydro-kinetic process. Since a large variety of systems (semiconductor substrate, resist and post exposure process) exist, the parameters of equation 2 need to be determined for all the different systems.

In mask making a similar complication manifests also the second step - the pattern-transfer into the imaging layer and/or substrate through the resist in both wet and/or dry etching.

The correction of proximity effects in the field of e-beam lithographic systems, is available by some commercial software packages that all deal with exposure dose optimization issues based on the principle of using double or multiple Gaussian approximations of the electron-scattering phenomena as described above. If the input parameters are determined from Monte Carlo simulation exclusively, then the calculations involve only the pure AEDD. Such results do not contain any information about additional non-linear effects from other influencing elements. One influencing element is the process, for example radiation-chemical events in the resist, thermal effects, dissolution behavior in development and etching in mask making. An other influencing element is the tool, (for example, electron-optical aberrations and space charge effects affecting the aerial image slope and/or edge acuity), dependent impacts affecting the resulting pattern deformation. On this account the inputs for correction schemes should be estimated by using physical behavioral models, which exactly describe all these effects and, in addition, even finely tune the values of these parameters obtained from experimental measurements.

For the correction process only properly selected numerical inputs can bring this system to work. Therefore great efforts have been taken to develop a quick and easy method for the numerical determination of process-depending input parameter sets required to determine the exposure correction algorithms. The flexible program package PROX-In should help the lithographer to find/determine these optimized numerical values.

Special care was taken to synchronize both the algorithms of the corrector and the PROX-In software, respectively, to obtain the same results in the simulation mode for identical input parameters. The present invention uses a semi-phenomenological concept

The proximity correction together with the fogging correction with the e-beam lithographic system 1 reduces the dimensional errors to <10nm on masks for the 100nm device generation and below.

Before starting "PROX-In", it is unavoidable to extract the following main numerical lithographic parameters directly from the set of specifically designed and exposed test patterns (needed as insert/setting parameters for the numerical calculation into PROX-In).

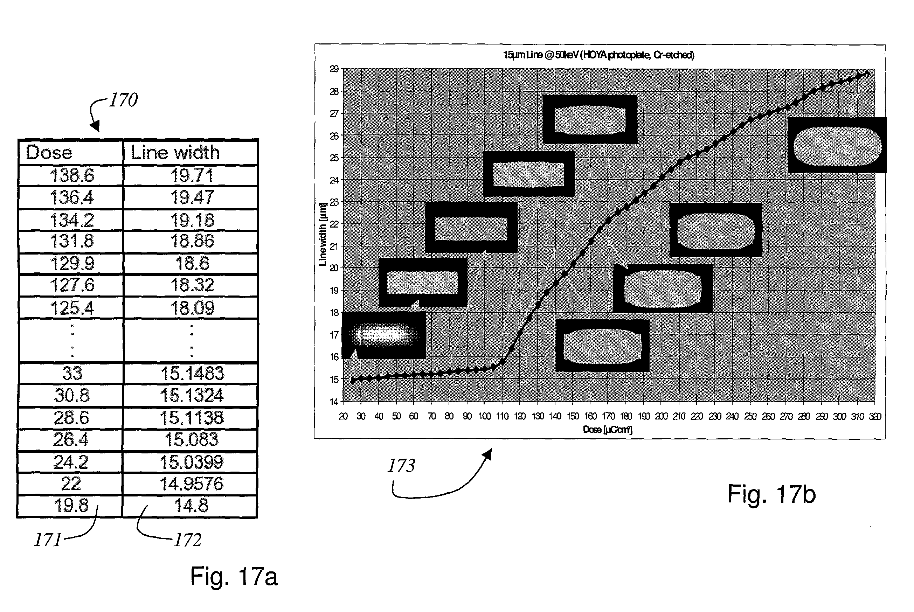

Fig. 17a shows a table 170 of the (* .BET)-File, for a preparation wherein the dose [$\mu C/cm^2$] is displayed vs. the exposed line width [$\mu m$].

Measurements should be performed on an isolated wide line exposed with various doses. The result 173 of the measurement is visualized in Fig. 17b. The measured line should be a pattern exposed as a long-isolated line of a width > $\beta$ (to "collect all backscattering electrons", i.e. for 50keV mask making $\geq 10\mu m$). The (* .BET) file (table 170) is written by using an arbitrary Text-Editor by direct insertion of the measured values as "Dose" [$\mu C/cm^2$] - Separator -"Linewidth" [$\mu m$] in two columns 171, 172, descending with dose value in ASCII-format, (see example in Fig. 17a for a $15\mu m$ wide line). The measurement is taken by CD-measurement tools (for example Leica LMS-IPRO, Leica LWM, CD-SEM, or the like).

The method is based on the analysis of the line width variation vs. exposure dose (see Fig. 17b). The dose is written on the abscissa and is increasing (with a fine step) from a smallest reasonable value through the optimum exposure (where the line width meets the target of $15\mu m$ up to higher values (to approx.10x the optimum dose). The measured line width is shown on the ordinate. A visualization of the whole effect of backscattering, together with all additional impacts from pre- and post-exposure processes is shown in Fig. 17b by the resulting line width and/or format. The specific $\beta$ parameter for the given process configuration can be calculated by inserting the (* .BET)-file into the algorithm working under "BETA-MANUAL" and/or "BETA-AUTO".

A second portion 180 of the main window 120 is headed as **"SIMULATION"** and serves for the "fine-tuning" of the numerical input parameter set on a selected pattern. The parameter tuning is based on "Back-Simulation" of the measured dimensional variations of a pattern depending on the applied dose and/or neighborhoods. One pattern is a wide single clear line. The line width variation versus exposure dose is based on results obtained and the corresponding **(* .BET)**-file (see Fig. 17a). A further possibility is relative Optimum Dose $\equiv$ Dose Factor versus the line width for isolated clear lines for a width-range from minimally resolvable lines up to 2-3$\mu m$ (depending on the process). ASCII-data from measurements are gained in the form of line width versus. dose factor from a **(* .TGT)** - file. The corresponding data can be extracted from measurements of non-corrected exposed test patterns . A **"PYR"** - pyramid-like pattern- line width variation as a function of the programmed gap-width between the measured line and large, symmetrically exposed, pads along the measured line (see Fig. 10). Measurement data are required in ASCII-format from measurements in the following form: gap width versus line width as **( * .PYR)** - file. "**DRT**" — Duty Ratio Test - line width variation as a function of the line/space-pitch - Measurement data are required in ASCII-format from measurements in the following form: Line width versus. pitch as (* **.DRT**) - file. - Data can be extracted from the measurements on non-corrected test patterns (see Fig. 11). The main task of this simulation part, as displayed in the second portion 180 of the main window 120 is to find (iteratively) a reasonable set of input-parameters for the lithography model used. The simulation shows the best possible fit with measurements. That means, the simulation should reconstruct the real situation of the measured pattern geometry variation.

The main task of this simulation part is to find a reasonable set of input parameters for the proximity correction and fogging correction of a lithography model used, where the simulation shows the best possible fit with measurements.

That means, the simulation should reconstruct the real situation of the measured pattern geometry variation.

Before pushing a Start button 181 for a simulation the user has to chose one of the four pattern types ("**LW vs. Q**", "**to Target...**","**PYR**", "**DRT**") from which the corresponding ASCII-file is available with measured data. It is also necessary to fill-in all active Edit-Windows 182 with relevant numerical values and select the required model approach using a 2, 3, or 4 Gaussian representation for the proximity effect plus an additional Gaussian function for the fogging effect.

Possible numerical ambiguities (e.g. not only one-value results and/or parameter values without a reasonable physical interpretation) may cause certain complications. Therefore we recommend to generally start the simulation with a "**2G**" 184 (two Gaussian) approach and as start values insert the $\beta$- and $\eta$- values obtained from the first rough approximation. As the starting value a number ranging between 0.05 - 0.1$\mu$m can be set.

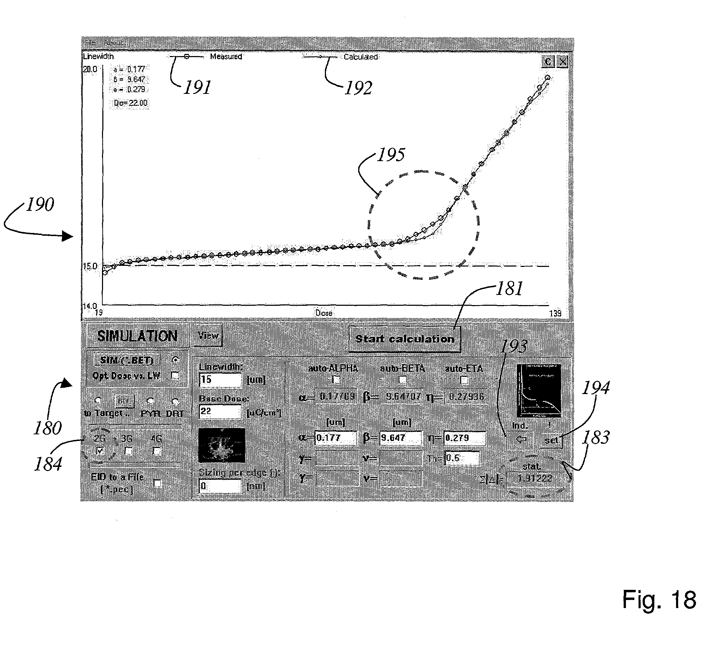

After starting the simulation a request for the corresponding ASCII-File appears (one of (* . BET), (* . TGT), (* . PYR), or (* . DRT) depending on the selected pattern type). If the file will be successfully read and interpreted by the program a new graphic window 190 (see Fig. 18) appears immediately in the top part of the second portion 180 of the main window 120 showing the results from the measurement 191 and related simulation 192 using the entered values in an appropriate graphic form.

Along with the graphics also a text information appears in the third part 123, located in the right-bottom side, of the main window 120 (see Fig. 12). The third part 123 contains the corresponding numerical comparison between experimental and calculated results with an evaluation of the fit-quality. The data can be directly handled in the third part 123 similarly as in an ordinary editor, i.e. mark the text, copy into clipboard, and also directly insert the copied ASCII-data into other software (e.g. Excel, ...) for further treatment.

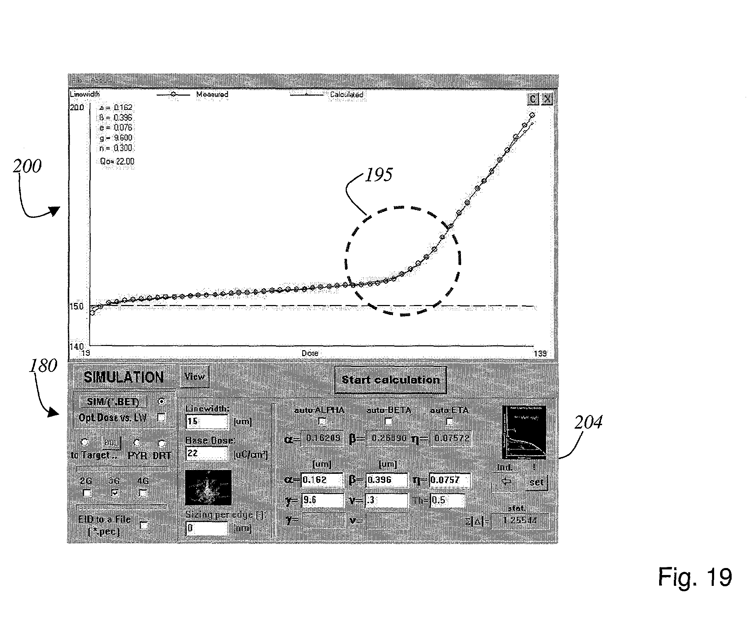

After each simulation step on the second portion 180 under "**stat**" 183 (see Fig. 18) a value appears indicating the quality of the just performed simulation. Generally, each step in the parameter-determination fitting process using the Back-Simulation method should tend to get the smallest possible value for "**stat**" 183 (e.g. see the difference in "stat" values between Fig. 18 and Fig. 19; obviously illustrating that Fig. 19 features the better fit 200).

The "**ind**" 193, 203 shows in form of an arrow "⇑" the quality-tendency of the fit among the fit-process. Pushing the "**Set**" button 194, 204 sets the current "**stat**" value as a min. for the quality evaluation and from now the indicator "**ind**" will show the fit-quality tendency in accordance to this value. "ind" - meaning : "⇑" worse; "⇓" - better, "⇐" - no significant change.

In case of a selected pattern type, except of "DRT", it is also possible to try separately each of the **"auto-ALPHA", "auto-BETA",** and **"auto-ETA"** functions (see Fig. 18) of the program (check the appropriate box, Note: only one must be checked at the same time!). The result is an optimized parameter value proposal for $\alpha$ or $\beta$ or $\eta$ appearing in the second portion 180 in red. If the calculated value proposal seems to be reliable, then it should be inserted into the appropriate Edit-Window below as a new value for the next simulation step. As a very first step in the auto-fit process it is recommended to start with the "**auto-ETA**" function - to find an approximately relevant and acceptable value of $\eta$. After inserting this value into the Edit-Window below the parameter-fit needs more iterations of many times through all input-parameters.

The boxes indicated as "3G" and "4G" (see the second portion 180 of the main window 120) are used to select more than two-Gaussian parameter sets. It often happens that some regions of the measurements cannot be satisfactorily fitted with simulations using the standard two Gaussian parameter sets (see Fig. 18; area marked with a dashed circle 195). In case the measured inputs of the line width variations are correct, this in reality could lead to a local failure of the optimised dose assignment for some combinations of patterns in the correction process. Using more than two Gaussians is in general possible in order to improve the quality of the fit (see Fig. 19).

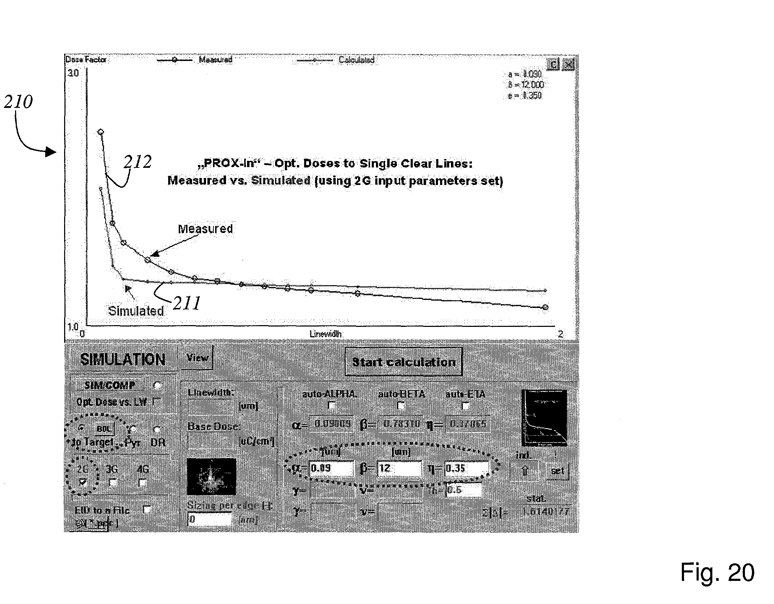

Fig. 20 shows a comparison 210 of the optimal doses for a measured line width 212 of a single clear line and the simulated one; using "2G" approximations. The calculated "Correction Curve" 211 using the "2G" approximation does not provide the best fit with respect to the measured data of the line width (proximity effect).

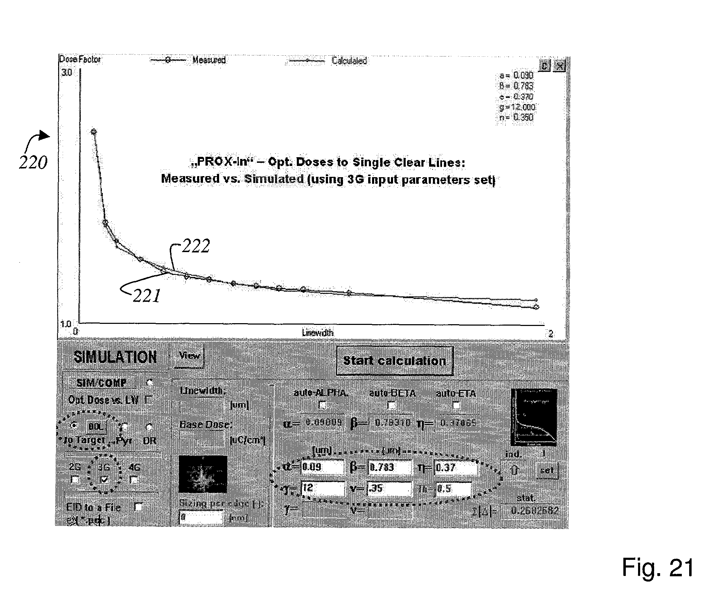

Fig. 21 shows a comparison 220 of the optimal doses for a measured line width of a single clear line and the simulated one, using "3G" approximations. The calculated "Correction Curve" 221 using the "3G" approximation provides the best fit with respect to the measured data 222 of the line width (proximity effect).

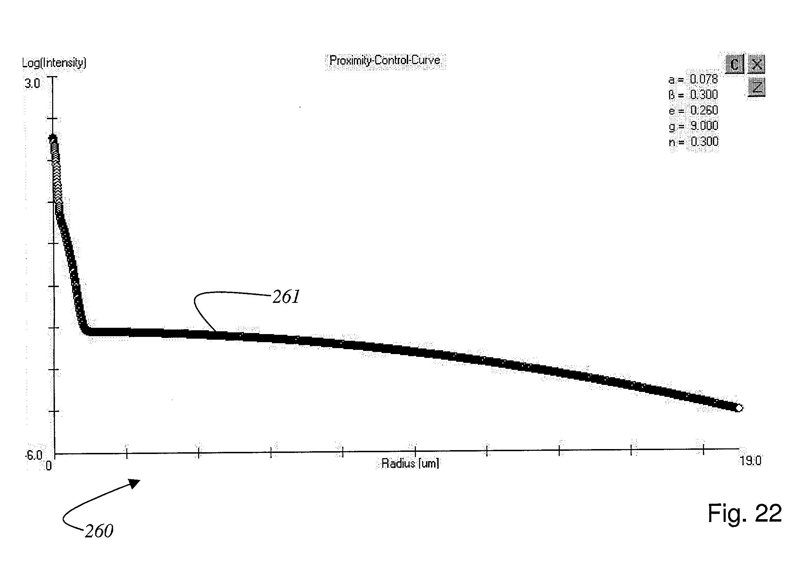

Fig. 22 shows a graph 230 representation of the resulting control function 231. The very last step in the whole parameter set determination process is the generation of the control function 231 for the exposure process optimization. The control function 231 is fully determined by the proximity input parameters $\alpha$, $\beta$, $\eta$, ... obtained.

The resulting control function 231 in the form of an "EID" (**E**xposure **I**ntensity **D**istribution) can be obtained in each step for one of the simulation steps after checking the **"EID to a File (* .pec)"** check-box. On the upper part of the display there appears a graph representation of the control function resulting as Radial Distance [$\mu$m] vs. Exposure Intensity [arbitrary units].

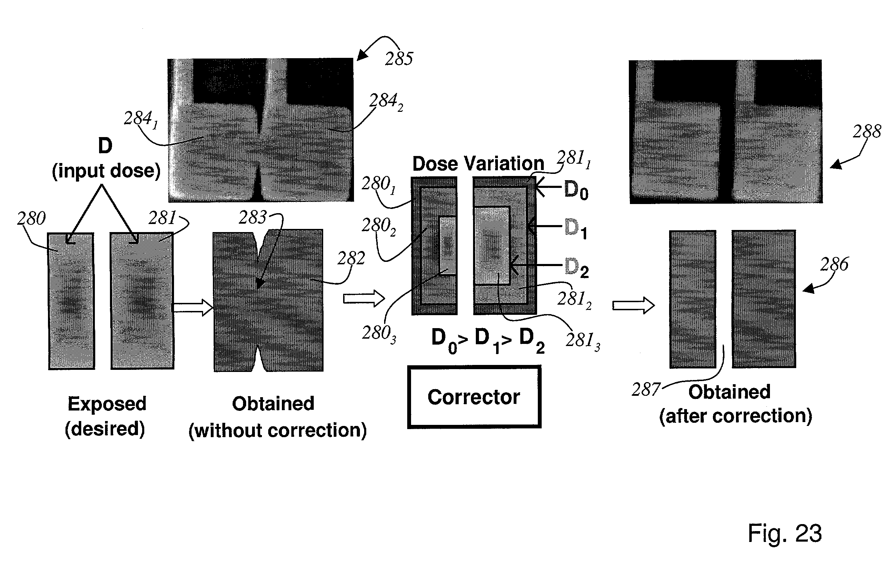

Fig. 23 shows a schematic representation of a pattern written with and without the applied control function. To a first and a second area 280 and 281 a defined e-beam dose is assigned. A schematic representation 282 of the pattern resulting from the illumination by the e-beam shows a connection 283 between the individual lands $284_1$ and $284_2$. According to the CAD-data it is expected that the lands $284_1$ and $284_2$ are separated. The e-beam illumination causes the undesired connection between the two lands $284_1$ and $284_2$. A real image 285 of the structured pattern shows the connection between the two lands $284_1$ and $284_2$. According to the invention the first and the second area 280 and 281 are divided into at least two sub-areas $280_1$, $280_2$, ..., $280_n$ and $281_1$, $281_2$, ..., $281_n$ wherein a different dose is assigned to the sub-areas. According to the present embodiment the areas 280 and 281 are divided into three sub-areas $280_1$, $280_2$, and $280_3$. To each sub-area $280_1$, $280_2$, and $280_3$ an individual dose is assigned, wherein the first sub-area $280_1$ is subjected to a dose $D_0$, the second sub-area $280_2$ is subjected to a dose $D_1$, and the third sub-area $280_3$ is subjected to a dose $D_2$. As a result of the inventive assignment of the various doses to the various sub-areas a structure is obtained which has the dimensions as required by the CAD-data. A schematic representation of the various resulting structure 286 shows that there is a clear separation between the two structures. The separation is defined by a straight line 287 with a constant width. A real image 288 of the patterned structure is shown as well.

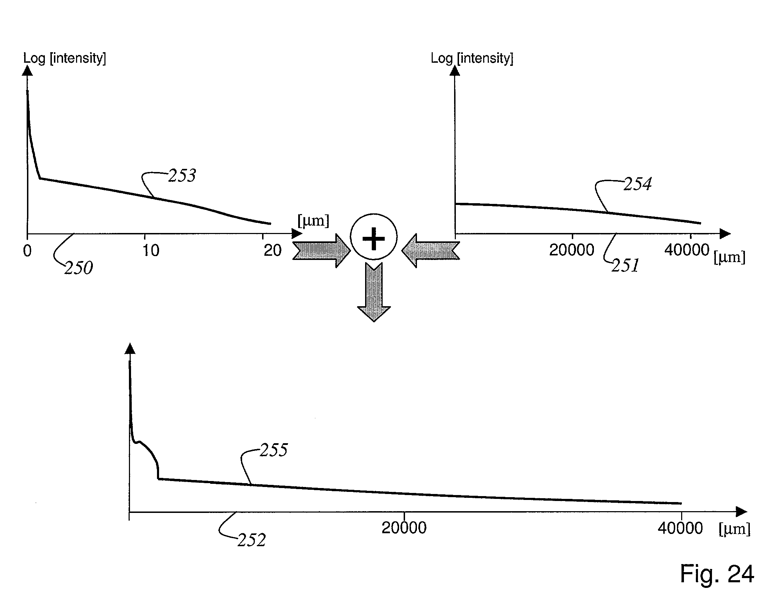

Fig. 24 shows in a first diagram 250 a graphical representation of the control function 253 for the proximity effect. A second diagram 251 is a graphical representation of the control function 254 for the fogging effect. A third diagram 252 shows a combined control function 255 for the proximity effect and the fogging effect.

Reference List:

| | |
|---|---|
| 1 | e-beam lithographic system |
| 2 | e-beam source |
| 3 | e-beam |
| 4 | substrate |
| 5 | pattern |
| 6 | stage |
| 7 | electric motor |
| 8 | electric motor |
| 9 | beam alignment coil |
| 10 | beam blanking unit |
| 11 | magnetic deflection unit |
| 12 | magnetic coil |
| 13 | position feedback device |
| 14 | electron detector |
| 15 | computer |
| 16 | interface |
| 17 | display |
| 20 | pattern |
| 21 | area |
| 22 | Gaussian beam |
| 23 | cross section |
| 30 | pattern |
| 31 | area |
| 32 | shaped beam |
| $32_1$ | different shape |
| $32_2$ | different shape |
| $32_3$ | different shape |
| 33 | cross section |
| 34 | arrow |
| 40 | PMMA-layer |
| 41 | GaAs substrate |
| 42 | trajectories |
| 43 | e-beam |
| 50 | diagram |
| 51 | electron beam energy |
| 52 | electron beam energy |
| 53 | electron beam energy |
| 54 | abscissa |
| 55 | ordinate |
| 60 | first test pattern |

| 61 | width |
|----|-------|
| 62 | exposed area |
| 63 | island |
| 64 | clear line |
| 65 | distance |
| 66 | exposed line in the middle of the island |
| 67 | distance |
| 70 | second test pattern |
| 71 | single line |
| 72 | unexposed area |
| 73 | distance |
| 74 | exposed area |
| 75 | measurement scan |
| 76 | width |
| 80 | diagram |
| 81 | abscissa |
| 82 | ordinate |
| 83 | first curve |
| 84 | second curve |
| 90 | diagram |
| 91 | abscissa |
| 92 | ordinate |
| 93 | first curve |
| 94 | second curve |
| 95 | width |
| 96 | width |
| 100 | first test pattern |
| 101 | line |
| 102 | pads |
| 103 | line width |
| 104 | gap width |
| 105 | points |
| 110 | second test pattern |
| 111 | line width |
| 112 | lines |
| 113 | pitches |
| 114 | array |
| 115 | bullet points |
| 116 | single-clear-line |
| 120 | input window |
| 121 | mark |
| 130 | table |
| 131 | first column |
| 132 | second column |
| 133 | third column |
| 134 | graph form |
| 135 | parameter set |
| 136 | measured data |
| 137 | calculated data |
| 140 | input window |
| 141 | mark |
| 150 | table |
| 151 | first column |
| 152 | second column |
| 153 | third column |
| 154 | graph form |
| 155 | parameter set |
| 156 | measured data |

| | |
|---|---|
| 157 | calculated data |
| 160 | main window |
| 161 | first part |
| $161_1$ | first sub-box |
| $161_2$ | second sub-box |
| $161_3$ | third sub-box |
| $161_4$ | fourth sub-box |
| 162 | second part |
| 163 | third part |
| 164 | text window |
| 170 | table |
| 171 | column |
| 172 | column |
| 173 | result |
| 180 | second portion |
| 181 | Start button |
| 182 | active Edit-Windows |
| 183 | stat |
| 184 | 2G |
| 190 | graphic window |
| 191 | results from the measurement |
| 192 | simulation |
| 193 | ind |
| 194 | Set button |
| 195 | dashed circle |
| 200 | better fit |
| 203 | "ind" |
| 210 | comparison |
| 211 | Correction Curve |
| 212 | measured line width |
| 220 | comparison |
| 221 | Correction Curve |
| 222 | measured data |
| 230 | graph |
| 231 | control function |
| 250 | first diagram |
| 251 | second diagram |
| 252 | third diagram |
| 253 | control function |
| 254 | control function |
| 255 | control function |
| 280 | first area |
| $280_1$ | sub-area |
| $280_2$ | sub-area |
| $280_n$ | sub-area |
| 281 | second area |
| $281_1$ | second area |
| $281_2$ | second area |
| $281_n$ | second area |
| 282 | schematic representation |
| 283 | connection |
| $284_1$ | individual land |
| $284_2$ | individual land |
| 285 | real image |
| 286 | resulting structure |
| 287 | straight line |
| 288 | real image |

**Claims**

1. Method for reducing the fogging effect in an electron beam lithography system wherein the exposure is controlled in order to obtain resulting pattern after processing which are conform to design data comprising the steps of:

   • exposing test patterns;
   • measuring the geometry of the resulting test structures within the test pattern and thereby obtaining a set of measurement data showing the influence of the fogging effect on the dimensions as required by the design data;
   • determining a numerical range of basic input parameters for a Gaussian function $G_{fog}$, describing the fogging effect, from the set of measurement data;
   • fitting a model for the fogging effect by individually changing at least the basic input parameters of the Gaussian function $G_{fog}$, by considering a proximity effect, to measurement data set and thereby obtaining an optimised set of parameters,
   • applying the correction function to an exposure control of the electron beam lithography system during the exposure of a pattern according to the design data.

2. The method as claimed in claim 1, wherein a proximity effect correction in an electron beam lithography system comprising the steps of:

   • exposing an arbitrary set patterns without applying the process for controlling the proximity correction;
   • measuring the geometry of the resulting test structures and thereby obtaining a set of measurement data;
   • determining a numerical range of proximity of basic input parameters , and $\eta$, from the set of measurement data;
   • fitting a model by individually changing at least the basic input parameters , and $\eta$ of a control function to measurement data set and thereby obtaining an optimised set of parameters,
   • applying the control function to an exposure control of the electron beam lithography system during the exposure of a pattern according to the design data.

3. The method as claimed in claim 1, wherein the control function for the proximity effect is a sum of at least two Gaussian functions.

4. The method as claimed in any of the claims 1 to 3, wherein function the control function for the proximity effect and the fogging effect is determined by:

$$ f(r) = \frac{1}{\pi(1+\eta)} \left\{ \frac{1}{\alpha^2} \exp(-\frac{r^2}{\alpha^2}) + \frac{\eta}{\beta^2} \exp(-\frac{r^2}{\beta^2}) \right\} + G_{fog} $$

   wherein a first term $\alpha$ - characterizes the short-range of forward scattering, a second term $\beta$ - the backscattering , a parameter $\eta$- is the deposited energy ratio of the back-scattering component to the forward scattering component, and r- is the distance from the point of electron incidence and $G_{fog}$ determines the control function considering the fogging effect

5. The method as claimed claim 4, wherein the control function for the proximity effect is determined by a sum of three Gaussian functions.

6. The method as claimed in claim 4, wherein the control function for the proximity effect is determined by a sum of four Gaussian functions.

7. The method as claimed in any previous claim, wherein with the use of the proximity correction control function and the fogging correction control function with the e-beam lithographic system the dimensional errors are reduced to less than 10nm for the 100nm device generation.

8. The process as claimed in claim 2, wherein the proximity control function is embedded in a PROX-In software.

Fig. 1

Fig. 2a

Fig. 2b

Fig. 3a

Fig. 3b

EP 1 612 833 A1

Fig. 4a

Fig. 4b

**Fogging Effect:**
**Comparison of different primary energies**

Fig. 5

EP 1 612 833 A1

Fig. 6

Fig. 7

EP 1 612 833 A1

Fig. 8

Fig. 9

Fig. 10

EP 1 612 833 A1

Fig. 11

Fig. 12

| GAP WIDTH [μm] | Measured [μm] | Calculated [μm] |
|---|---|---|
| 50 | 2 | 2,001 |
| 45 | 2,001 | 2,001 |
| 40 | 2,002 | 2,001 |
| 35 | 2,002 | 2,001 |
| 30 | 2,002 | 2,001 |
| 25 | 2,002 | 2,001 |
| 20 | 2,003 | 2,001 |
| 18 | 2,004 | 2,001 |
| 16 | 2,004 | 2,001 |
| 14 | 2,005 | 2,003 |
| 12 | 2,006 | 2,005 |
| 10 | 2,011 | 2,01 |
| 8 | 2,02 | 2,018 |
| 6 | 2,034 | 2,03 |
| 4 | 2,051 | 2,05 |
| 2 | 2,077 | 2,081 |
| 1 | 2,104 | 2,11 |
| 0,9 | 2,112 | 2,114 |
| 0,8 | 2,126 | 2,118 |
| 0,7 | 2,142 | 2,125 |
| 0,6 | 2,143 | 2,133 |
| 0,5 | 2,153 | 2,149 |

Fig. 13

EP 1 612 833 A1

Fig. 13a

EP 1 612 833 A1

140

**SIMULATION**

LW vs. Q (*.BET)

Opt. Dose vs. LW

BDL

to Target...  PYR  DRT

141

Fig. 14

150

| Duty Ratio | Ratio | Measured [µm] | Calculated [µm] |
|------------|-------|---------------|-----------------|
| (1:1) | 1 | 0,649 | 0,649 |
| (1:1,2) | 1,2 | 0,645 | 0,644 |
| (1:1,4) | 1,4 | 0,642 | 0,639 |
| (1:1,6) | 1,6 | 0,639 | 0,636 |
| (1:1,8) | 1,8 | 0,635 | 0,633 |
| (1:2) | 2 | 0,633 | 0,631 |
| (1:3) | 3 | 0,625 | 0,622 |
| (1:4) | 4 | 0,618 | 0,617 |
| (1:5) | 5 | 0,614 | 0,614 |
| (1:10) | 10 | 0,607 | 0,607 |
| (1:20) | 20 | 0,6 | 0,602 |

151    152    153

Fig. 15

Fig. 15a

Fig. 16

170

| Dose | Line width |
|---|---|
| 138.6 | 19.71 |
| 136.4 | 19.47 |
| 134.2 | 19.18 |
| 131.8 | 18.86 |
| 129.9 | 18.6 |
| 127.6 | 18.32 |
| 125.4 | 18.09 |
| ⋮ | ⋮ |
| 33 | 15.1483 |
| 30.8 | 15.1324 |
| 28.6 | 15.1138 |
| 26.4 | 15.083 |
| 24.2 | 15.0399 |
| 22 | 14.9576 |
| 19.8 | 14.8 |

171  172

Fig. 17a

173

Fig. 17b

Fig. 18

Fig. 19

Fig. 20

Fig. 21

EP 1 612 833 A1

Fig. 22

**D (input dose)**

280 281

Exposed (desired)

283

Obtained (without correction)

285

284₁ 284₂

**Dose Variation** 281₁

280₁
280₂
282
280₃

D₀
D₁
D₂

281₂
281₃

D₀ > D₁ > D₂

**Corrector**

288

286

287

Obtained (after correction)

Fig. 23

Fig. 24

**European Patent Office**

## EUROPEAN SEARCH REPORT

Application Number

EP 04 10 3019

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | SEUNG-HUNE YANG ET AL.: "Proximity Effect Correction Optimization Considering Fogging and Loading Effects Compensation" PROCEEDINGS OF SPIE, vol. 4689, 2002, pages 977-984, XP002312824 | 1 | H01J37/302 |
| Y | * abstract * <br> * page 977, paragraph 1-3 * <br> * page 978, paragraph 1-3 * <br> * page 979, paragraph 1; figures 2,3 * <br> * page 980, paragraph 1; figure 4 * <br> * page 981, paragraph 2 - page 982, paragraph 4 * <br> * page 982, paragraph 5 - page 983, paragraph 1; figure 7 * <br> ----- | 2-8 | |
| X | PATENT ABSTRACTS OF JAPAN vol. 1999, no. 12, 29 October 1999 (1999-10-29) & JP 11 204415 A (TOSHIBA CORP), 30 July 1999 (1999-07-30) * abstract * <br> ----- <br> -/-- | 1 | |

TECHNICAL FIELDS SEARCHED (Int.Cl.7)

H01J

The present search report has been drawn up for all claims

| Place of search | Date of completion of the search | Examiner |
|---|---|---|
| The Hague | 9 February 2005 | Hofmann, K |

**European Patent Office**

## EUROPEAN SEARCH REPORT

Application Number

EP 04 10 3019

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | CUI Z ET AL: "Proximity Correction of Chemically Amplified Resists for Electron Beam Lithography" MICROELECTRONIC ENGINEERING, ELSEVIER PUBLISHERS BV., AMSTERDAM, NL, vol. 41-42, 1 March 1998 (1998-03-01), pages 183-186, XP004111703 ISSN: 0167-9317 * abstract * * page 183, left-hand column, paragraph 2 * * page 184, right-hand column; table 1 * * page 185, right-hand column; figures 8a,8b * * page 186, left-hand column - right-hand column; figures 9b,10b * | 2-8 | |
| A | SIMECEK M. ET AL.: "A New Approach of E-beam Proximity Effect Correction for High-Resolution Applications" JPN. J. APPL. PHYS., vol. 37, no. 12B, 1998, pages 6774-6778, XP002307640 * page 6774, left-hand column, paragraph 1 - right-hand column, paragraph 1 * * page 6776, left-hand column, paragraph 3 - right-hand column, paragraph 1 * | 1,2 | **TECHNICAL FIELDS SEARCHED** (Int.Cl.7) |

-/--

The present search report has been drawn up for all claims

| Place of search | Date of completion of the search | Examiner |
|---|---|---|
| The Hague | 9 February 2005 | Hofmann, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**European Patent Office**

**EUROPEAN SEARCH REPORT**

Application Number

EP 04 10 3019

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | DONG-IL PARK ET AL.: "Modeling and Correction of Global CD Uniformity Caused by Fogging and Loading Effects in 90nm Node CAR Processes" PROCEEDINGS OF SPIE, vol. 5130, 2003, pages 78-85, XP002312825 * abstract * * page 79, paragraphs 1,3; figure 1 * * page 80, paragraphs 2,3; figure 2 * * page 81, paragraph 2; figure 3 * * page 82, paragraphs 2,3 - page 83, paragraph 3; figure 5 * * page 84, paragraph 1 - paragraph 2; figures 6,7 * * page 85, paragraph 2 * ----- | 1,2 | |

TECHNICAL FIELDS
SEARCHED     (Int.Cl.7)

The present search report has been drawn up for all claims

| Place of search | Date of completion of the search | Examiner |
|---|---|---|
| The Hague | 9 February 2005 | Hofmann, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 10 3019

This annex lists the patent family members relating to the patent documents cited in the above-mentioned European search report.
The members are as contained in the European Patent Office EDP file on
The European Patent Office is in no way liable for these particulars which are merely given for the purpose of information.

09-02-2005

| Patent document cited in search report | | Publication date | Patent family member(s) | | Publication date |
|---|---|---|---|---|---|
| JP 11204415 | A | 30-07-1999 | JP | 3466900 B2 | 17-11-2003 |

For more details about this annex : see Official Journal of the European Patent Office, No. 12/82

EPO FORM P0459